# EUROPÄISCHE PATENTSCHRIFT

(11) **EP 1 914 814 B1**
(45) Veröffentlichungstag und Bekanntmachung des Hinweises auf die Patenterteilung: **24.03.2010**
(21) Anmeldenummer: 08001217.2
(22) Anmeldetag: 13.09.2005
(51) Int. Cl.: H01L 33/00, H01L 21/60

(54) **Beleuchtungseinrichtung mit optoelektronischem Bauelement mit drahtloser Kontaktierung**
Illumination device with opto-electronic component comprising a wireless contact
Dispositif d'éclairage avec composant optoélectronique doté d'un contact sans fil

(30) Priorität: 30.09.2004 DE 102004047680; 15.10.2004 DE 102004050371
(43) Veröffentlichungstag der Anmeldung: 23.04.2008
(62) Teilanmeldung aus: 05788493.4
(73) Patentinhaber: OSRAM Opto Semiconductors GmbH, 93055 Regensburg (DE)
(72) Erfinder: Günther, Ewald Karl Michael, Dr., 93128 Regenstauf (DE); Sorg, Jörg Erich, 93053 Regensburg (DE); Stath, Norbert, Dr., 93049 Regensburg (DE)
(74) Vertreter: Epping - Hermann - Fischer

(56) Entgegenhaltungen:
- WO-A-02/065558
- US-A- 4 936 808
- US-A- 5 538 919
- US-A1- 2004 041 159
- MARGALITH T ET AL: "Indium tin oxide contacts to gallium nitride optoelectronic devices" APPLIED PHYSICS LETTERS, AIP, AMERICAN INSTITUTE OF PHYSICS, MELVILLE, NY, US, Bd. 74, Nr. 26, 28. Juni 1999 (1999-06-28), Seiten 3930-3932, XP012022993 ISSN: 0003-6951

## Beschreibung

Die Erfindung betrifft eine Beleuchtungseinrichtung gemäß dem Oberbegriff des Patentanspruchs 1 und ein Verfahren zur Herstellung einer Beleuchtungseinrichtung nach dem Oberbegriff des Patentanspruchs 23.

Optoelektronische Bauelemente, wie zum Beispiel lichtemittierende Dioden (LEDs), weisen in der Regel zwei gegenüberliegende Kontaktflächen auf, wobei oftmals die erste Kontaktfläche auf einen elektrisch leitfähigen Träger, beispielsweise auf einen mit einer Metallisierungsschicht versehenen Bereich eines Chipgehäuses, montiert wird.

Die elektrische Kontaktierung der gegenüberliegenden zweiten Kontaktfläche eines Halbleiterchips gestaltet sich üblicherweise schwieriger, da diese in der Regel nicht an den vorgesehenen zweiten Anschlussbereich des Trägerkörpers angrenzt. Diese zweite Kontaktierung wird herkömmlicherweise mit einem Bonddraht hergestellt. Zur Herstellung einer elektrisch leitenden Verbindung zwischen dem Bonddraht und der zur kontaktierenden Chipoberfläche wird ein Bereich der Chipoberfläche mit einer metallischen Schicht, dem sogenannten Bondpad versehen. Diese Metallschicht hat aber den Nachteil, dass sie optisch nicht transparent ist und dadurch ein Teil des im Chip generierten Lichts absorbiert wird. Eine Reduzierung der Fläche des Bondpads ist jedoch technisch nur beschränkt möglich und erhöht den Herstellungsaufwand.

Um das Problem der Abschattung eines Teils der zur Strahlungsauskopplung vorgesehenen Oberfläche eines optoelektronischen Bauelements zu vermindern, ist aus der JP 09283801 A bekannt, eine auf der Oberfläche des Halbleiterchips angeordnete Elektrode mit einer elektrisch leitfähigen transparenten Schicht aus Indium-Zinn-Oxid (ITO) drahtlos zu kontaktieren. Die Seitenflanken des Halbleiterchips werden dabei durch eine isolierende Schicht aus SiO₂ von der leitfähigen transparenten Schicht elektrisch isoliert.

Aus der WO 98/12757 ist bekannt, einen optoelektronischen Halbleiterchip, der in herkömmlicher Weise mit einem Bonddraht kontaktiert ist, in eine Vergussmasse einzubetten, die Lumineszenz-Konversionsstoffe enthält, um zumindest einen Teil der von dem Halbleiterchip emittierten Strahlung zu größeren Wellenlängen hin zu konvertieren. Auf diese Weise kann zum Beispiel mit einem Halbleiterchip, der blaues oder ultraviolettes Licht emittiert, mischfarbiges oder weißes Licht erzeugt werden.

Der Erfindung liegt die Aufgabe zugrunde, ein verbessertes optoelektronisches Bauelement mit einer drahtlosen Kontaktierung anzugeben, bei dem der Halbleiterchip vor Umgebungseinflüssen geschützt ist, die mit Möglichkeit zur Wellenlängenkonversion der emittierten Strahlung besteht, und der Herstellungsaufwand vergleichsweise gering ist. Ferner soll ein vorteilhaftes Verfahren zur Herstellung eines derartigen optoelektronischen Bauelements angegeben werden.

Es wird eine Beleuchtungseinrichtung und ein Verfahren zur Herstellung einer Beleuchtungseinrichtung gemäß den unabhängigen Ansprüchen angegeben. Vorteilhafte Ausgestaltungen und Weiterbildungen der Erfindung sind Gegenstand der abhängigen Ansprüche.

Bei einem erfindungsgemäßen optoelektronischen Bauelement, das Strahlung in eine Hauptstrahlungsrichtung emittiert, mit einem Halbleiterchip, der eine erste Hauptfläche, eine erste Kontaktfläche, und eine der ersten Hauptfläche gegenüberliegende zweite Hauptfläche mit einer zweiten Kontaktfläche aufweist, sowie mit einem Trägerkörper, der zwei voneinander elektrisch isolierte Anschlussbereiche aufweist, wobei der Halbleiterchip mit der ersten Hauptfläche auf dem Trägerkörper befestigt ist und die erste Kontaktfläche mit dem ersten Anschlussbereich elektrisch leitend verbunden ist, sind der Halbleiterchip und der Trägerkörper mit einer transparenten, elektrisch isolierenden Verkapselungsschicht versehen. Dabei wird die in der Hauptstrahlungsrichtung emittierte Strahlung durch die Verkapselungsschicht ausgekoppelt. Weiterhin ist eine elektrisch leitfähige Schicht von der zweiten Kontaktfläche über einen Teilbereich der Verkapselungsschicht zu dem zweiten elektrischen Anschlussbereich des Trägerkörpers geführt, welche die zweite Kontaktfläche mit dem zweiten Anschlussbereich elektrisch leitend verbindet.

Die elektrisch isolierende Verkapselungsschicht erfüllt bei dem erfindungsgemäßen optoelektronischen Bauelement vorteilhaft mehrere Funktionen. Da die Verkapselungsschicht elektrisch isolierend ist, verhindert sie, dass durch die aufgebrachte elektrisch leitfähige Schicht ein Kurzschluss entsteht. Dies wäre zum Beispiel der Fall, wenn ein pn-Übergang des Halbeleiterchips durch das Aufbringen der elektrisch leitfähigen Schicht an der Seitenflanke des Halbleiterchips kurzgeschlossen würde oder die beiden Anschlussbereiche des Trägerkörpers durch die elektrisch leitfähige Schicht miteinander verbunden würden. Weiterhin schützt die Verkapselungsschicht den Halbleiterchip vor Umgebungseinflüssen, insbesondere vor Schmutz und Feuchtigkeit.

Da die von dem optoelektronischen Bauelement in der Hauptstrahlungsrichtung emittierte Strahlung durch die Verkapselungsschicht ausgekoppelt wird, kann die Verkapselungsschicht vorteilhaft auch ein Lumineszenz-Konversionsmaterial enthalten, um beispielsweise mit einem ultraviolette oder blaue Strahlung emittierenden Halbleiterchip Weißlicht zu erzeugen. Geeignete Lumineszenz-Konversionsmaterialien, wie zum Beispiel YAG:Ce (Y₃Al₅O₁₂:Ce³⁺), sind aus der WO 98/12757 bekannt, deren Inhalt hiermit durch Referenz aufgenommen wird. Im Hinblick auf die Effizienz der Lumineszenzkonversion ist es besonders vorteilhaft, wenn die Verkapselungsschicht unmittelbar an die zur Strahlungsauskopplung vorgesehene Oberfläche des Halbleiterchips angrenzt.

Bevorzugt enthält das optoelektronische Bauelement einen strahlungsemittierenden Halbleiterchip aus einem III-V-Verbindungshalbleitermaterial, insbesondere aus einem Nitridverbindungshalbleitermaterial.

Die Verkapselungsschicht ist beispielsweise eine Kunststoffschicht. Bevorzugt ist sie eine Silikonschicht, da sich Silikon durch eine hohe Strahlungsbeständigkeit, insbesondere gegenüber UV-Licht, auszeichnet.

Besonders bevorzugt ist die Verkapselungsschicht eine Glasschicht. Eine Verkapselungsschicht aus einem Glas hat den Vorteil, dass ein Glas einen thermischen Ausdehnungskoeffizienten aufweist, der in der Regel besser an den Halbleiterchip angepasst ist als bei einem Kunststoff. Dadurch werden temperaturbedingte mechanische Spannungen, die zu Rissen in der Verkapselungsschicht oder sogar zu einem Ablösen der Verkapselungsschicht führen könnten, vorteilhaft vermindert. Ebenfalls wird ein durch Temperaturspannungen bedingtes Ablösen der elektrisch leitfähigen Schicht von der Verkapselungsschicht vermieden. Weiterhin zeichnet sich ein Glas durch eine im Vergleich zu einem Kunststoff geringere Aufnahme von Feuchtigkeit aus. Ferner ist auch die Beständigkeit gegen ultraviolette Strahlung bei einer Verkapselungsschicht aus einem Glas sehr hoch.

Die erste Hauptfläche des Halbleiterchips kann gleichzeitig die erste Kontaktfläche sein, und der Halbleiterchip an dieser Kontaktfläche auf dem ersten Anschlussbereich des Trägerkörpers befestigt sein. Beispielsweise kann die erste Kontaktfläche des Halbleiterchips die Rückseite eines Substrats sein, die bevorzugt mit einer Metallisierung versehen ist, und die elektrische Verbindung zum ersten Anschlussbereich des Trägerkörpers mit einer Lötverbindung oder einem elektrisch leitfähigen Klebstoff erfolgen.

Alternativ ist es aber auch möglich, dass sich sowohl die erste als auch die zweite Kontaktfläche auf der zweiten Hauptfläche des Halbleiterchips befinden und beide Kontaktflächen mit voneinander isolierten elektrisch leitfähigen Schichten mit jeweils einem der beiden Anschlussbereiche des Trägerkörpers verbunden sind. Dies ist vorteilhaft bei Halbleiterchips, die ein isolierendes Substrat enthalten, zum Beispiel ein Saphirsubstrat. Isolierende Saphirsubstrate werden zum Beispiel oftmals bei Halbleiterchips auf der Basis von Nitridverbindungshalbleitern verwendet.

Die elektrisch leitfähige Schicht ist beispielsweise eine strukturierte Metallschicht. Diese Metallschicht ist vorzugsweise derart strukturiert, dass sie nur einen geringen Teil der zweiten Hauptfläche des Halbleiterchips bedeckt, um eine Absorption der von dem optoelektronischen Bauelement emittierten Strahlung in der Metallschicht zu vermindern. Die Strukturierung der Metallschicht kann zum Beispiel mittels Photolithographie erfolgen.

Besonders bevorzugt ist die elektrisch leitfähige Schicht eine für die emittierte Strahlung transparente Schicht. Dies ist insbesondere zur Verminderung des Herstellungsaufwands vorteilhaft, da die transparente Schicht nicht von den zur Strahlungsauskopplung vorgesehenen Bereichen der isolierenden Schicht entfernt werden muss, und somit keine Strukturierung notwendig ist. Die elektrisch leitfähige Schicht kann beispielsweise ein transparentes leitfähiges Oxid (TCO) enthalten, insbesondere Indium-Zinn-Oxid (ITO).

Wenn eine potentialfreie Oberfläche des optoelektronischen Bauelements erwünscht ist, ist vorteilhaft eine isolierende Deckschicht, beispielsweise eine Lackschicht, auf die elektrisch leitfähige Schicht aufgebracht.

Bei einem erfindungsgemäßen Verfahren zur Herstellung eines optoelektronischen Bauelements, das Strahlung in eine Hauptstrahlungsrichtung emittiert, mit einem Halbleiterchip, der eine erste Hauptfläche, eine erste Kontaktfläche und eine der ersten Hauptfläche gegenüberliegende zweite Hauptfläche mit einer zweiten Kontaktfläche aufweist, sowie mit einem Trägerkörper, der zwei elektrisch voneinander isolierte Anschlussbereiche aufweist, wird der Halbleiterchip mit der ersten Hauptfläche auf den Trägerkörper montiert, nachfolgend eine transparente isolierende Verkapselungsschicht auf den Halbleiterchip und den Trägerkörper aufgebracht, eine erste Ausnehmung in der Verkapselungsschicht zur zumindest teilweisen Freilegung der zweiten Kontaktfläche des Halbleiterchips und eine zweite Ausnehmung in der Verkapselungsschicht zur zumindest teilweisen Freilegung des zweiten Anschlussbereichs des Trägerkörpers erzeugt. Nachfolgend wird eine elektrisch leitfähige Schicht zur Herstellung einer elektrisch leitfähigen Verbindung zwischen der zweiten Kontaktfläche des Halbleiterchips und dem zweiten Anschlussbereich des Trägerkörpers aufgebracht.

Die Verkapselungsschicht ist vorzugsweise eine Kunststoffschicht. Diese kann beispielsweise durch Auflaminieren einer Kunststofffolie, durch Aufdrucken oder Aufsprühen einer Polymerlösung aufgebracht werden.

Bei einer besonders bevorzugten Variante des erfindungsgemäßen Verfahrens wird zunächst eine Precursor-Schicht auf den Halbleiterchip und den Trägerkörper aufgebracht, beispielsweise mittels eines Sol-Gel-Verfahrens, durch Aufdampfen oder durch Aufschleudern (Spincoating) einer Suspension. Durch eine erste Temperaturbehandlung werden die organischen Bestandteile der Precursor-Schicht nachfolgend entfernt. Die so entstandene Schicht wird nachfolgend mit einer zweiten Temperaturbehandlung verdichtet, um eine Verkapselungsschicht in Form einer Glasschicht zu erzeugen.

Die erste und zweite Ausnehmung in der Verkapselungsschicht werden vorzugsweise dadurch hergestellt, dass die Verkapselungsschicht in diesen Bereichen mittels einer Laserbestrahlung abgetragen wird.

Die elektrisch leitfähige Schicht wird vorteilhaft mit einem PVD-Verfahren, beispielsweise mittels Sputtern, aufgebracht und nachfolgend mittels galvanischer Abscheidung verstärkt.

Alternativ kann die elektrisch leitfähige Schicht auch mit einem Druckverfahren, insbesondere mit einem Siebdruckverfahren, aufgebracht werden. Ferner kann die elektrisch leitfähige Schicht auch mit einem Aufsprüh- oder Aufschleuderverfahren (Spincoating) erzeugt werden.

Ein erfindungsgemäßes optoelektronisches Bauelement ist besonders vorteilhaft für die Verwendung in Beleuchtungseinrichtungen, insbesondere in Hochleistungs-Beleuchtungseinrichtungen wie beispielsweise Scheinwerfern, geeignet. Dabei weist das optoelektronische Bauelement oder die Beleuchtungseinrichtung gemäß einer zweckmäßigen Ausführungsform eine Vielzahl von Halbleiterchips auf. Insbesondere kann das optoelektronische Bauelement in einem Frontscheinwerfer eines Kraftfahrzeugs oder als Lichtquelle in Projektionsapplikationen, beispielsweise in Bild- und/oder Video-Projektoren, eingesetzt werden.

Die Beleuchtungseinrichtung weist mit Vorteil mindestens ein optisches Element auf. Bevorzugt ist jedem Halbleiterchip des optoelektronischen Bauelements mindestens ein optisches Element zugeordnet. Das optische Element dient zur Ausbildung eines Strahlenkegels mit einer möglichst hohen Strahlenintensität und einer möglichst geringen Divergenz.

Bevorzugt ist mehreren Halbleiterchips gemeinsam ein optisches Element zugeordnet. Dies hat beispielsweise den Vorteil einer vereinfachten Montage, verglichen mit dem Fall, dass jedem Halbleiterchip ein eigenes optisches Element zugeordnet ist. Zusätzlich oder alternativ sind die Halbleiterchips in mindestens zwei Gruppen unterteilt, denen jeweils ein eigenes optisches Element zugeordnet ist. Selbstverständlich ist es auch möglich, jedem Halbleiterchip ein eigenes optisches Element zuzuordnen. Es ist auch möglich, dass das Bauelement oder die Beleuchtungseinrichtung einen einzigen Halbleiterchip aufweist, dem ein einziges optisches Element zugeordnet ist.

Das optische Element ist bevorzugt in der Art eines nichtabbildenden optischen Konzentrators ausgebildet, der, verglichen mit einer üblichen Verwendung eines Konzentrators, für eine Durchstrahlung in umgekehrter Richtung vorgesehen ist. Durch die Verwendung mindestens eines derartigen optischen Elementes kann die Divergenz des von der Lichtquelle emittierten Lichts mit Vorteil auf effiziente Weise verringert werden.

Hierbei ist es besonders vorteilhaft, wenn ein Lichteingang des optischen Konzentrators möglichst nahe an den Halbleiterchips positioniert ist, was mit der angegebenen drahtlosen Kontaktierung mit Vorteil besonders gut möglich ist, da diese, verglichen mit einer Kontaktierung mittels eines Bonddrahtes, mit einer besonders geringen Höhe ausgebildet werden kann. Zweckmäßigerweise wird der Raumwinkel, in dem das Licht aus dem optischen Element emittiert wird, mittels des optischen Elementes möglichst nah an den Halbleiterchips verkleinert, wo eine Querschnittsfläche des Strahlenkegels noch klein ist. Dies ist insbesondere dann erforderlich, wenn eine möglichst hohe Strahlungsstärke auf eine möglichst kleine Fläche projiziert werden soll, wie das bei Scheinwerferapplikationen oder Projektionseinrichtungen der Fall ist.

Eine wichtige Erhaltungsgröße in der geometrischen Optik ist dabei das Etendue, das heißt der Lichtleitwert. Sie ist das Produkt aus dem Flächeninhalt einer Lichtquelle und dem Raumwinkel, in den sie abstrahlt. Das Etendue beschreibt die Ausdehnung eines Lichtkegels beliebiger Intensität. Die Erhaltung des Etendue hat unter anderem zur Konsequenz, dass man das Licht einer diffusen Strahlungsquelle, zum Beispiel eines Halbleiterchips, nicht mehr konzentrieren, das heißt nicht mehr auf eine Fläche mit kleinerer Ausdehnung umlenken kann, ohne Verluste in Kauf zu nehmen, weshalb es vorteilhaft ist, wenn das Lichtbündel mit einem möglichst kleinen Querschnitt in das optische Element eintritt. Eben dies wird durch die angegebene Kontaktierung auf besonders vorteilhafte Weise ermöglicht.

In einer besonders zweckmäßigen Ausführungsform wird das Licht mittels des optischen Elementes derart stark kollimiert, das heißt die Divergenz des Lichtes wird derart stark verringert, dass es aus dem optischen Element in einem Strahlenkegel mit einem Öffnungswinkel emittiert wird, der kleiner als oder gleich 25°, bevorzugt kleiner als oder gleich 20°, besonders bevorzugt kleiner als oder gleich 15° ist.

Der optische Konzentrator ist mit Vorteil ein CPC-, CEC- oder CHC-artiger optischer Konzentrator, womit hierbei sowie im Folgenden ein Konzentrator gemeint ist, dessen reflektierende Seitenwände zumindest teilweise und/oder zumindest weitestgehend die Form eines zusammengesetzten parabolischen Konzentrators (Compound Parabolic Concentrator, CPC), eines zusammengesetzten elliptischen Konzentrators (Compound Elliptic Concentrator, CEC) und/oder eines zusammengesetzten hyperbolischen Konzentrators (Compound Hyperbolic Concentrator, CHC) aufweist.

Mit besonderem vorteil sind die reflektierenden Flächen des optischen Elements teilweise oder vollständig als Freiformflächen ausgebildet, um eine gewünschte Abstrahlcharakteristik optimal einzustellen. In seiner Grundform ähnelt das optische Element dabei bevorzugt einem CPC, einem CEC oder einem CHC.

Alternativ weist der Konzentrator mit Vorteil Seitenwände auf, die einen Strahlungseingang mit einem Strahlungsausgang verbinden und die derart ausgebildet sind, dass auf den Seitenwänden verlaufende direkte Verbindungslinien zwischen dem Strahlungseingang und dem Strahlungsausgang im wesentlichen gerade verlaufen.

Das optische Element ist mit Vorteil in der Art eines dielektrischen Konzentrators ausgebildet und weist einen Grundkörper in Form eines Vollkörpers mit einem dielektrischen Material von geeignetem Brechungsindex auf, so dass in das optische Element eingekoppeltes Licht durch Totalreflektion an seitlichen Grenzflächen des Vollkörpers zum umgebenden Medium reflektiert wird. Durch die Ausnutzung der Totalreflektion kann eine Absorption des Lichts bei dessen Reflektion weitestgehend vermieden werden.

Mit Vorteil weist das optische Element einen Strahlungsausgang mit einer linsenartig gewölbten Grenzfläche auf. Dadurch lässt sich eine weitergehende Verringerung der Divergenz des Lichts erzielen.

Zweckmäßigerweise ist ein Teil benachbarter Halbleiterchips oder sind alle benachbarten Halbleiter mit einem möglichst geringen Abstand zueinander angeordnet. Der Abstand beträgt bevorzugt weniger als oder gleich 300 µm, besonders bevorzugt weniger als oder gleich 100 µm und ist größer als oder gleich 0 µm. Diese Maßnahme ist für das Erzielen einer möglichst hohen Strahldichte in von Vorteil. Gleichzeitig kann bei derart dicht angeordneten Halbleiterchips deren elektrische Kontaktierung mittels Bonddrähten unvorteilhaft sein, wogegen die angegebene drahtlose Kontaktierung für die elektrische Kontaktierung eng zueinander angeordneter Chips besonders vorteilhaft ist.

Die Erfindung wird im folgenden anhand von Ausführungsbeispielen in Zusammenhang mit den Figuren 1 bis 8 näher erläutert.

### Es zeigen:

Figur 1 eine schematische Darstellung eines Querschnitts durch ein erstes Ausführungsbeispiel eines optoelektronischen Bauelements gemäß der Erfindung,
Figur 2 eine schematische Darstellung eines ersten Ausführungsbeispiels eines erfindungsgemäßen Verfahrens anhand von Zwischenschritten,
Figur 3 eine schematische Darstellung einer Variante des Aufbringens der Verkapselungsschicht und/oder der Deckschicht bei einem zweiten Ausführungsbeispiel eines erfindungsgemäßen Verfahrens,
Figur 4 eine schematische perspektivische Darstellung eines ersten Ausführungsbeispiels der Beleuchtungseinrichtung,
Figur 5 eine schematische perspektivische Darstellung eines zweiten Ausführungsbeispiels der Beleuchtungseinrichtung,
Figur 6 eine schematische perspektivische Darstellung eines dritten Ausführungsbeispiels der Beleuchtungseinrichtung,
Figur 7 eine schematische Schnittansicht eines Teils eines vierten Ausführungsbeispiels der Beleuchtungseinrichtung, und
Figur 8 eine schematische Schnittansicht eines Teils eines fünften Ausführungsbeispiels der Beleuchtungseinrichtung.

Gleiche oder gleichwirkende Elemente sind in den Figuren mit den gleichen Bezugszeichen versehen.

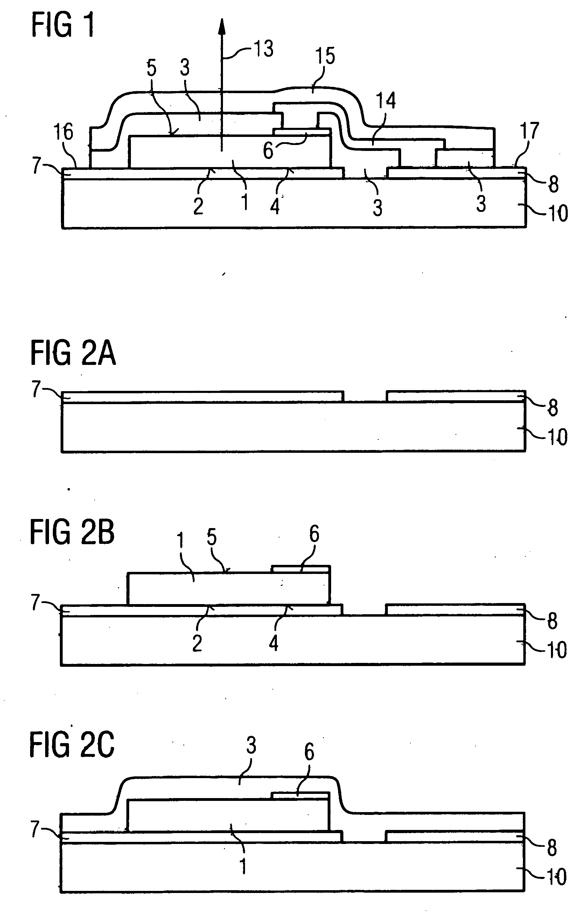

Das in Figur 1 dargestellte erste Ausführungsbeispiel eines optoelektronischen Bauelements gemäß der Erfindung enthält einen Trägerkörper 10, auf den zwei Kontaktmetallisierungen aufgebracht sind, die einen ersten Anschlussbereich 7 und einen zweiten Anschlussbereich 8 ausbilden. Ein Halbleiterchip 1 ist mit einer ersten Hauptfläche 2, die bei diesem Ausführungsbeispiel gleichzeitig die erste Kontaktfläche 4 darstellt, auf den ersten Anschlussbereich 7 montiert. Die Montage des Halbleiterchips 1 auf den ersten Anschlussbereich 7 erfolgt zum Beispiel durch Löten oder Kleben. An einer zweiten Hauptfläche 5 des Halbleiterchips 1, die der ersten Hauptfläche 2 gegenüberliegt, weist der Halbleiterchip 1 eine zweite Kontaktfläche 6 auf.

Der Halbleiterchip 1 und der Trägerkörper 10 sind mit einer Verkapselungsschicht 3 versehen. Die Verkapselungsschicht 3 ist vorzugsweise eine Kunststoffschicht. Insbesondere kann es sich um eine Silikonschicht handeln, da sich eine Silikonschicht durch eine besonders gute Strahlungsbeständigkeit auszeichnet. Besonders bevorzugt ist die Verkapselungsschicht 3 eine Glasschicht.

Die zweite Kontaktfläche 6 und der zweite Anschlussbereich 8 sind durch eine elektrisch leitfähige Schicht 14, die über einen Teilbereich der Verkapselungsschicht 3 geführt ist, miteinander verbunden. Die elektrisch leitfähige Schicht 14 enthält zum Beispiel ein Metall oder ein elektrisch leitfähiges transparentes Oxid (TCO), beispielsweise Indium-Zinn-Oxid (ITO), ZnO:Al oder SnO:Sb.

Um eine potentialfreie Oberfläche zu erhalten, ist auf die elektrisch leitfähige Schicht 14 vorteilhaft eine isolierende Deckschicht 15, beispielsweise eine Lackschicht aufgebracht. Im Fall einer transparenten isolierenden Deckschicht 15 muss diese vorteilhaft nicht strukturiert werden und kann daher ganzflächig auf das optoelektronische Bauelement aufgebracht sein. Vorteilhaft sind Teilbereiche 16, 17 der Anschlussflächen 7, 8 von der Verkapselungsschicht 3 und der Deckschicht 15 freigelegt, so dass in diesen freigelegten Teilbereichen 16, 17 elektrische Anschlüsse zur Stromversorgung des optoelektronischen Bauelements angebracht werden können.

Durch die Verkapselungsschicht 3 wird der Halbleiterchip 1 vor Umgebungseinflüssen, insbesondere vor Schmutz oder Feuchtigkeit, geschützt. Die Verkapselungsschicht 3 fungiert weiterhin als isolierender Träger der elektrisch leitfähigen Schicht 14, der einen Kurzschluss der Seitenflanke des Halbleiterchips 1 und/oder der beiden Anschlussflächen 7 oder 8 des Trägerkörpers verhindert.

Außerdem wird auch die von dem Halbleiterchip 1 in eine Hauptstrahlungsrichtung 13 emittierte Strahlung durch die Verkapselungsschicht 3 aus dem optoelektronischen Bauelement ausgekoppelt. Dies hat den Vorteil, dass der Verkapselungsschicht 3 ein Lumineszenz-Konversionsmaterial zugesetzt sein kann, mit dem die Wellenlänge von zumindest einem Teil der emittierten Strahlung zu größeren Wellenlängen hin verschoben wird. Insbesondere kann auf diese Weise Weißlicht erzeugt werden, in dem die von einem im blauen oder ultravioletten Spektralbereich emittierenden Halbleiterchip 1 erzeugte Strahlung teilweise in den komplementären gelben Spektralbereich konvertiert wird. Dazu wird bevorzugt ein Halbleiterchip 1 mit einer strahlungserzeugenden aktiven Zone, die ein Nitridverbindungshalbleitermaterial wie zum Beispiel GaN, AlGaN, InGaN oder InGaAlN enthält, verwendet.

Ein Ausführungsbeispiel eines erfindungsgemäßen Verfahrens wird im folgenden anhand der Figuren 2A bis 2F anhand von schematisch dargestellten Zwischenschritten näher erläutert.

Figur 2A zeigt einen Trägerkörper 10, auf dem zwei voneinander elektrisch isolierte Anschlussbereiche 7, 8 ausgebildet sind, zum Beispiel durch Aufbringen und Strukturieren einer Metallisierungsschicht.

Bei dem in Figur 2B dargestellten Zwischenschritt wird ein Halbleiterchip 1, der eine erste Hauptfläche 2 und eine zweite Hauptfläche 5 aufweist, mit einer ersten Kontaktfläche 4, die bei diesem Ausführungsbeispiel gleich der zweiten Hauptfläche 2 des Halbleiterchips 1 ist, auf den ersten Anschlussbereich 7 des Trägerkörpers 10 montiert. Die Montage des Halbleiterchips 1 auf den Trägerkörper 10 erfolgt beispielsweise mittels einer Lötverbindung oder einem elektrisch leitfähigen Klebstoff. An der zweiten Hauptfläche 5 weist der Halbleiterchip 1 eine zweite Kontaktfläche 6 auf, die zum Beispiel aus einer Kontaktschicht oder Kontaktschichtenfolge gebildet wird, die auf die zweite Hauptfläche 5 aufgebracht ist und zum Beispiel mittels Photolithographie strukturiert wird.

In Figur 2C ist ein Zwischenschritt dargestellt, bei dem auf den Halbleiterchip 1 und den mit den Anschlussbereichen 7, 8 versehenen Trägerkörper 10 eine Verkapselungsschicht 3 aufgebracht wird. Das Aufbringen der Verkapselungsschicht 3 erfolgt vorzugsweise durch das Aufsprühen oder Aufschleudern (Spincoating) einer Polymerlösung. Weiterhin ist auch ein Druckverfahren, insbesondere Siebdruck, zum Aufbringen der Verkapselungsschicht 3 vorteilhaft.

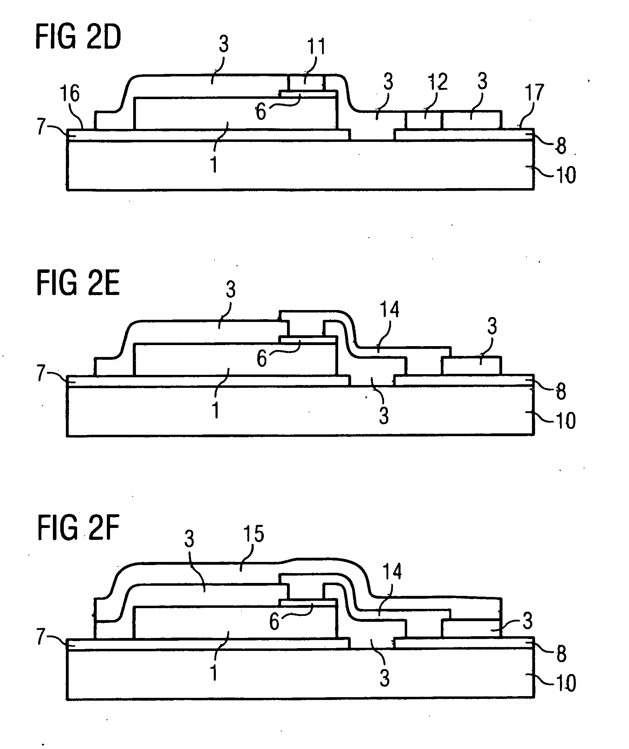

Bei dem in Figur 2D dargestellten Verfahrensschritt werden eine erste Ausnehmung 11, durch die ein Teilbereich der zweiten Kontaktfläche 6 freigelegt wird, und eine zweite Ausnehmung 12, durch die ein Teilbereich des zweiten Anschlussbereichs 8 des Trägerkörpers 10 freigelegt wird, in der Verkapselungsschicht 3 erzeugt. Die Ausnehmungen 11, 12 werden vorzugsweise mit einer Laserbearbeitung erzeugt. Vorteilhaft wird auch ein Teilbereich 16 des ersten Anschlussbereichs 7 und ein Teilbereich 17 des zweiten Anschlussbereichs 8 freigelegt, um das Anbringen elektrischer Anschlüsse an dem Trägerkörper 10 des optoelektronischen Bauelements zu ermöglichen.

Bei dem in Figur 2E dargestellten Zwischenschritt wird die zuvor durch die Ausnehmung 11 freigelegte zweite Kontaktfläche 6 durch eine elektrisch leitfähige Schicht 14 mit dem zuvor durch die Ausnehmung 12 freigelegten Bereich der zweiten Anschlussfläche 8 elektrisch leitfähig verbunden.

Die elektrisch leitfähige Schicht 14 ist zum Beispiel eine Metallschicht. Diese wird beispielsweise derart aufgebracht, dass zunächst eine vergleichsweise dünne Metallschicht, die beispielsweise etwa 100 nm dick ist, ganzflächig auf die Verkapselungsschicht 3 aufgebracht wird. Dies kann zum Beispiel durch Aufdampfen oder Sputtern erfolgen. Nachfolgend wird eine Photolackschicht (nicht dargestellt) auf die Metallschicht aufgebracht, in der mittels Phototechnik eine Ausnehmung in dem Bereich erzeugt wird, in dem die elektrisch leitfähige Schicht 14 die zweite Kontaktfläche 6 mit dem zweiten Anschlussbereich 8 verbinden soll.

In dem Bereich der Ausnehmung in der Photolackschicht wird die zuvor aufgebrachte Metallschicht durch eine galvanische Abscheidung verstärkt. Dies erfolgt vorteilhaft derart, dass die Metallschicht in dem galvanisch verstärkten Bereich wesentlich dicker ist als die zuvor ganzflächig aufgebrachte Metallschicht. Beispielsweise kann die Dicke der Metallschicht in dem galvanisch verstärkten Bereich mehrere µm betragen. Nachfolgend wird die Photolackschicht entfernt und ein Ätzprozess durchgeführt, mit dem die Metallschicht in dem nicht galvanisch verstärkten Bereich vollständig abgetragen wird. In dem galvanisch verstärkten Bereich wird die Metallschicht aufgrund ihrer größeren Dicke dagegen nur zu einem Teil abgetragen, so dass sie in diesem Bereich als elektrisch leitfähige Schicht 14 verbleibt.

Alternativ ist es auch möglich, dass die elektrisch leitfähige Schicht 14 direkt in strukturierter Form auf die Verkapselungsschicht 3 aufgebracht wird. Dies kann beispielsweise mit einem Druckverfahren, insbesondere mit einem Siebdruckverfahren, erfolgen.

Eine Strukturierung oder ein strukturiertes Aufbringen der elektrisch leitfähigen Schicht 14 ist vorteilhaft nicht erforderlich, wenn eine für die emittierte Strahlung transparente elektrisch leitfähige Schicht 14 aufgebracht wird. Als elektrisch leitfähige transparente Schicht ist insbesondere ein transparentes leitfähiges Oxid (TCO) vorzugsweise Indium-Zinn-Oxid (ITO), oder alternativ eine elektrisch leitfähige Kunststoffschicht geeignet. Die elektrisch leitfähige transparente Schicht wird vorzugsweise durch Aufdampfen, Aufdrucken, Aufsprühen oder Aufschleudern (Spincoating) aufgebracht.

Bei dem in Figur 2F dargestellten Verfahrensschritt wird eine elektrisch isolierende Deckschicht 15 aufgebracht. Die isolierende Deckschicht 15 ist vorzugsweise eine Kunststoffschicht, zum Beispiel eine Lackschicht. Die isolierende Deckschicht 15 bedeckt insbesondere die elektrisch leitfähige Schicht 14, um eine potentialfreie Oberfläche zu erzeugen.

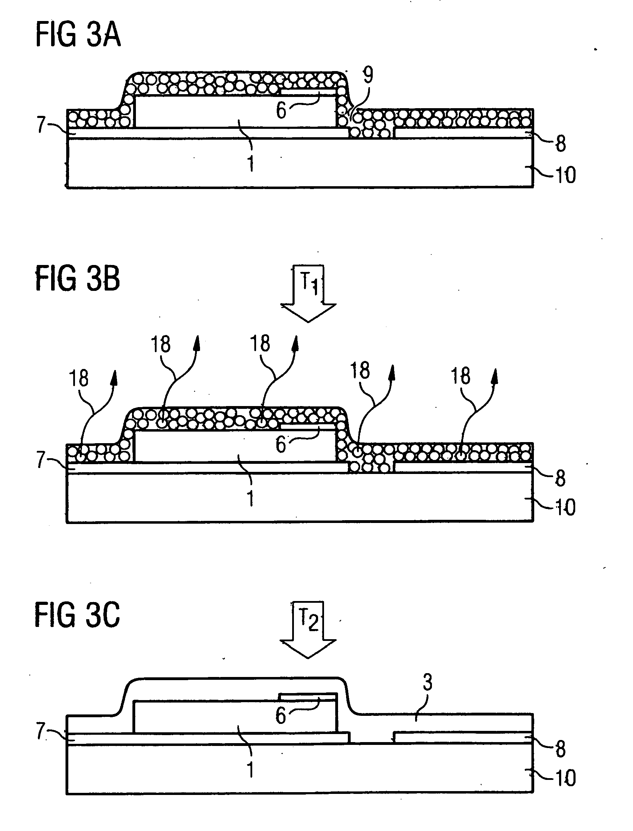

Eine alternative Variante des Aufbringens der Verkapselungsschicht 3, also des zuvor in der Figur 2C dargestellten Zwischenschritts, wird im folgenden anhand der Figuren 3A, 3B und 3C erläutert.

Dabei wird auf den Halbleiterchip 1 und den Trägerkörper 10 zunächst eine Precursor-Schicht 9 aufgebracht, die sowohl organische als auch anorganische Bestandteile enthält.

Das Aufbringen der Precursor-Schicht erfolgt beispielsweise mittels einem Sol-Gel-Verfahren, durch Aufdampfen, Sputtern, Aufsprühen oder durch Aufschleudern (Spincoating) einer Suspension.

Durch eine Temperaturbehandlung bei einer Temperatur T₁ von vorzugsweise etwa 200 °C bis 400 °C für etwa 4 h bis 8 h in einer neutralen N₂-Atmosphäre oder unter geringem O₂-Partialdruck werden die organischen Bestandteile der Precursor-Schicht 9, wie in Fig. 3B durch die Pfeile 18 angedeutet, entfernt.

Die so entstandene Schicht wird nachfolgend, wie in Fig. 3C schematisch dargestellt ist, mit einem Sinterprozess verdichtet, um die Verkapselungsschicht 3 zu erzeugen. Das Sintern erfolgt durch eine weitere Temperaturbehandlung bei einer Temperatur T₂ von vorzugsweise etwa 300 °C bis 500 °C für etwa 4 h bis 8 h. Abhängig von der Art der Glasschicht wird das Sintern vorzugsweise unter einer reduzierenden oder oxidierenden Atmosphäre durchgeführt.

Die in den Figuren 3A, 3B und 3C beschriebenen Verfahrensschritte können in analoger Weise auch zur Herstellung einer Deckschicht 15, die aus einem Glas besteht, verwendet werden. In diesem Fall werden diese Verfahrensschritte bevorzugt ein erstes Mal durchgeführt, um eine Verkapselungsschicht 3, die aus einem Glas besteht, zu erzeugen, und nach dem Aufbringen der elektrisch leitfähigen Schicht 14 wiederholt, um eine Deckschicht 15 aus einem Glas abzuscheiden.

Durch eine mehrfache Wiederholung des Aufbringens einer elektrisch isolierenden Schicht und einer elektrisch leitfähigen Schicht können auch mehrlagige Verschaltungen realisiert werden. Dies ist insbesondere für LED-Module, die mehrere Halbleiterchips enthalten, vorteilhaft.

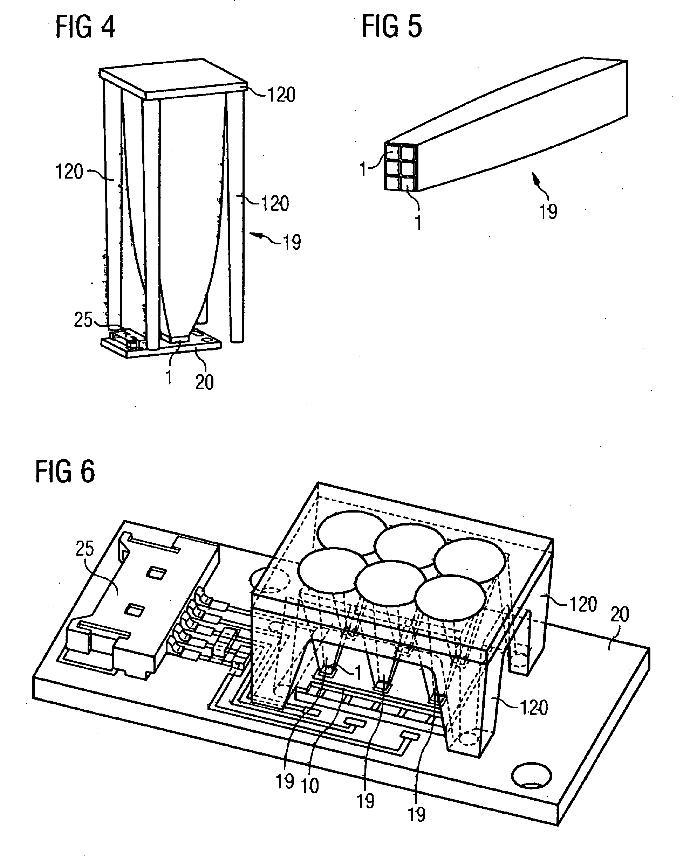

In den Figuren 4 bis 8 sind Beleuchtungseinrichtungen mit mindestens einem optoelektronischen Bauelement dargestellt, die jeweils mindestens ein optisches Element 19 aufweisen, wobei jedem Halbleiterchip 1 des optoelektronischen Bauelements ein optisches Element zugeordnet ist.

Bei dem in Figur 6 dargestellten Ausführungsbeispiel sind auf der Lichtquelle 2 über den Halbleiterchips eine Mehrzahl optischer Elemente 19 angeordnet, die zum Beispiel einstückig miteinander ausgebildet sind. Das in Figur 4 dargestellte optoelektronische Bauelement weist dagegen ein einziges optisches Element auf. Dieses optische Element 19 ist CPCartig ausgebildet.

Jeder Halbleiterchip 1 des optoelektronischen Bauelements ist beispielsweise einem einzigen optischen Element 19 zugeordnet. Ein den Halbleiterchips zugewandter Strahleneingang der optischen Elemente weist eine Strahlungseingangsöffnung, deren Seiten z.B. ≤ 1,5 mal einer entsprechenden horizontalen Kantenlänge der Halbleiterchips, bevorzugt von ≤ 1,25 mal dieser Kantenlänge ist. Ordnet man einen derart kleinen Strahleneingang möglichst nah am Halbleiterchip an, kann man eine Divergenz der von den Halbleiterchips emittierten Strahlung auf effektive Weise verringern und einen Strahlenkegel mit einer hohen Leuchtdichte erzeugen.

Statt jedem Halbleiterchip ein einziges eigenes optisches Element 19 zuzuordnen, kann das optische Element 19 auch für eine Mehrzahl von Halbleiterchips 1 vorgesehen sein, wie das beispielsweise bei dem optischen Element 19 des in Figur 5 dargestellten Bauelements der Fall ist. Dieses optische Element 19 ist auch in der Art eines CPC ausgebildet. Das optische Element 19 ist beispielsweise für sechs Halbleiterchips 1 vorgesehen.

Zur Erwirkung einer möglichst hohen Effizienz sollte die Halbleiterchips 1 möglichst nah beieinander angeordnet sein. Zumindest ein Teil benachbarter Halbleiterchips 1 weisen beispielsweise einen Abstand von ≤ 50 µm zueinander auf. Besonders bevorzugt weisen diese Halbleiterchips im wesentlichen keinen Abstand zueinander auf.

Als Alternative zu einem CPC-artigen Konzentrator weist das optische Element 19 zum Beispiel Seitenwände auf, die in geraden Linien von dem Strahleneingang zum Strahlenausgang verlaufen. Ein Beispiel für derartige optische Elemente 19 ist in Figur 6 dargestellt. Bei derartigen optischen Elementen 19 ist der Strahlenausgang bevorzugt mit einer sphärischen oder asphärischen Linse versehen bzw. in der Art einer derartige Linse nach außen gewölbt.

Der Vorteil einer asphärischen Wölbung, verglichen mit einer sphärischen Wölbung, ist, dass die asphärische Wölbung beispielsweise mit zunehmendem Abstand von der optischen Achse des optischen Elements 19 abnimmt. Dadurch wird dem Umstand Rechnung getragen, dass der Strahlenkegel, dessen Divergenz durch das optische Element 19 zu verringern ist, keine punktförmige Lichtstrahlungsquelle, sondern einen Strahlungsquelle mit einer gewissen Ausdehnung ist.

Ein derartiges optisches Element mit gerade vom Strahleneingang zum Strahlenausgang verlaufenden reflektierenden Wänden hat verglichen mit einem CPC-artigen optischen Element den Vorteil, dass mit ihm eine vergleichbare Verringerung der Divergenz eines Strahlenkegels bei gleichzeitig signifikanter Verringerung der Bauhöhe des optischen Elements 19 erzielt werden kann. Ein weiterer Vorteil derartiger optischer Elemente ist, dass ihre geraden Seitenflächen einfacher mittels eines Spritzverfahrens wie beispielsweise Spritzgießen oder Spritzpressen hergestellt werden können, während die Ausbildung gewölbter Seitenflächen wie bei CPC-artigen Konzentratoren vergleichsweise schwierig ist.

Bei dem optischen Element handelt es sich bevorzugt um einen dielektrischen Konzentrator mit einem Grundkörper aus einem dielektrischen Material. Alternativ ist jedoch auch die Verwendung eines Konzentrators mit einem Grundkörper, der einen entsprechenden Hohlraum mit reflektierenden Innenwänden definiert, möglich.

Wenn das optische Element 19 in der Art eines dielektrischen Konzentrators ausgebildet ist, sind in der Regel zusätzliche Befestigungsvorrichtungen nötig, um das optische Element 19 auf oder relativ zu den Halbleiterchips zu positionieren.

Die in den Figuren 4 und 6 dargestellten optischen Elemente weisen Halteelemente 120 auf, die sich in der Nähe des Strahlenausgangs des optischen Elements bzw. der optischen Elemente 19 von dem dielektrischen Grundkörper weg erstrecken und seitlich von diesem wegragen sowie in einem Abstand zu dem Grundkörper in Richtung des Strahleneingangs verlaufen.

Die Halteelemente 120 können beispielsweise säulenartige Elemente umfassen, auf denen die optischen Elemente aufgestellt und somit relativ zu den Halbleiterchips 1 positioniert werden können.

Als Alternative zu derartigen Halteelementen 120 können die optischen Elemente 19 auch mittels separater Halterungsvorrichtungen montiert und positioniert werden. Beispielsweise können sie in einen separaten Rahmen gesteckt werden.

Die in den Figuren 4 und 6 dargestellten Bauelemente sind optoelektronische Module, die einen Modulträger 20 aufweisen. Auf oder in dem Modulträger sind elektrische Leiterbahnen und ein Gegenstecker 25 ausgebildet, über den das Modul mittels eines entsprechenden Steckers elektrisch angeschlossen werden kann.

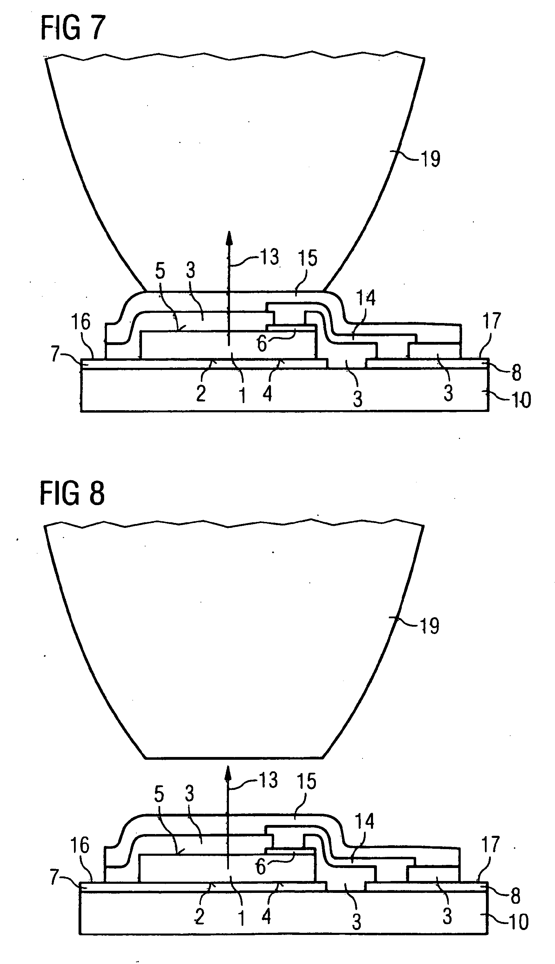

Bei dem in Figur 7 dargestellten Bauelement ist das optische Element 19 unmittelbar derart auf der isolierenden Deckschicht 15 aufgebracht, dass der Strahleneingang des optischen Elementes 19 an dieser angrenzt. Die Deckschicht 15 fungiert dabei als ein Koppelmaterial für das optische Element. Alternativ kann das Koppelmaterial auch in Form einer zusätzlichen Schicht auf dem Halbleiterchip 1 aufgebracht werden. Unter einem "Koppelmaterial" ist beispielsweise ein dielektrisches Material zu verstehen, das für die von den Halbleiterchips 1 emittierte Strahlung durchlässig ist und einen Brechungsindex aufweist, der bevorzugt demjenigen eines Halbleitermaterials der Halbleiterchips 1 entspricht, so dass Fresnel-Verluste und Totalreflexionen an Grenzflächen zwischen dem Halbleiterchip 1 und dem optischen Element 19 signifikant verringert sind.

Fresnel-Verluste sind Verluste aufgrund von Reflexionen an Grenzflächen, an denen es einen Brechungsindexsprung gibt. Ein typisches Beispiel ist der Brechungsindexsprung zwischen Luft und einem dielektrischen Material, beispielsweise beim Eintritt oder Austritt von elektromagnetischer Strahlung in ein bzw. aus einem optischen Element.

Der Halbleiterchip 1 ist also mittels des Koppelmaterials optisch an den dielektrischen Grundkörper des optischen Elements 19 angekoppelt. Das Koppelmaterial ist beispielsweise ein strahlungsdurchlässiges Gel mit einem Brechungsindex, der entweder an den Brechungsindex des dielektrischen Körpers des optischen Elements 19 oder an den Brechungsindex eines Halbleitermaterials der Halbleiterchips 1 angepasst ist oder zwischen den Brechungsindizes dieser beiden Materialien liegt. Alternativ zu einem Gel kann beispielsweise auch ein Epoxydharz oder ein lackartiges Material verwendet werden.

Der Brechungsindex des Koppelmaterials liegt bevorzugt zwischen dem des dielektrischen Körpers des optischen Elements 19 und eines Halbleitermaterials der Halbleiterchips 1. Wesentlich ist, dass der Brechungsindex signifikant größer als 1 ist. Beispielsweise wird ein Koppelmaterial für das Koppelmedium verwendet, dessen Brechungsindex größer als 1,3, bevorzugt größer als 1,4 ist. Hierfür kommen z.B. Silikone in Frage. Es sind aber auch andere Stoffe wie z.B. Flüssigkeiten als Koppelmedium möglich. Wasser hat beispielsweise einen Brechungsindex von größer als etwa 1,3 und ist als Koppelmedium grundsätzlich geeignet.

Bei dem in Figur 8 dargestellten Ausführungsbeispiel besteht zwischen dem Halbleiterchip 1 und dem optischen Element 19 ein Spalt 5, beispielsweise ein Luftspalt. Alternativ kann der Spalt 5 auch mit einem anderen Gas gefüllt sein und es ist ebenso möglich, dass in dem Spalt 5 ein Vakuum herrscht. Der Spalt bewirkt, dass ein hochdivergenter Anteil der vom Halbleiterchip 1 emittierten Strahlung aufgrund von Reflexionen an den Grenzflächen in geringerem Maße in das optische Element 19 einkoppelt als ein niederdivergenter Anteil. Dies kann für die Erzeugung von in hohem Maße kollimierten Strahlenkegeln sowie bei Anwendungen vorteilhaft sein, bei denen ein hochdivergenter Anteil stören könnte. Ein Beispiel hierfür sind Projektionsanwendungen.

Bei dem in Figur 7 dargestellten Ausführungsbeispiel beträgt der Abstand des Strahleneingangs des optischen Elements zu dem Halbleiterchip 1 weniger als 100 µm z.B. nur etwa 60 µm. Bei dem in Figur 8 dargestellten Ausführungsbeispiel beträgt der Abstand des Strahleneingangs des optischen Elements zu dem Halbleiterchip z.B. 180 µm.

## Patentansprüche

1. Beleuchtungseinrichtung mit einem Halbleiterchip (1), der eine erste Hauptfläche (2), eine erste Kontaktfläche (4), und eine der ersten Hauptfläche (2) gegenüberliegende zweite Hauptfläche (5) mit einer zweiten Kontaktfläche (6) aufweist, sowie mit einem Trägerkörper (10), auf dem der Halbleiterchip (1) mit der ersten Hauptfläche (2) befestigt ist,
wobei die erste Kontaktfläche elektrisch leitend mit einem ersten Anschlussbereich auf dem Trägerkörper verbunden ist,
**dadurch gekennzeichnet, dass**
- der Halbleiterchip (1) und der Trägerkörper (10) mit einer transparenten, elektrisch isolierenden Verkapselungsschicht (3) versehen sind,
- dem Halbleiterchip ein optisches Element zugeordnet ist,
- eine in einer Hauptstrahlungsrichtung (13) emittierte Strahlung des Halbleiterchips durch die Verkapselungsschicht (3) transmittiert und in das optische Element eingekoppelt wird, und
- zwischen dem optischen Element und der zweiten Hauptfläche ein Teil einer elektrisch leitfähigen Schicht (14) angeordnet ist, die von der zweiten Kontaktfläche (6) über einen Teilbereich der Verkapselungsschicht (3) geführt ist, zum elektrisch leitenden Verbinden der zweiten Kontaktfläche mit einem zweiten Anschlussbereich (8) auf dem Tragerkörper, wobei der zweite Anschlußbereich von dem ersten Anschlussbereich isoliert ist.

2. Beleuchtungseinrichtung nach Anspruch 1,
**dadurch gekennzeichnet, dass**
die Beleuchtungseinrichtung ein Scheinwerfer oder eine Projektionsapplikation ist.

3. Beleuchtungseinrichtung nach einem der Ansprüche 1 und 2, **dadurch gekennzeichnet, dass** das optische Element in der Art eines nichtabbildenden optischen Konzentrators ausgebildet ist, der, verglichen mit einer üblichen Verwendung eines Konzentrators, für eine Durchstrahlung in umgekehrter Richtung vorgesehen ist.

4. Beleuchtungseinrichtung nach Anspruch 3, **dadurch gekennzeichnet, dass** das optische Element ein optischer Konzentrator in der Art eines zusammengesetzten parabolischen Konzentrators, in der Art eines zusammengesetzten elliptischen Konzentrators oder in der Art eines zusammengesetzten hyperbolischen Konzentrators ist.

5. Beleuchtungseinrichtung nach Anspruch 3, **dadurch gekennzeichnet, dass** der Konzentrator Seitenwände aufweist, die einen Strahlungseingang mit einem Strahlungsausgang des Konzentrators verbinden und die derart ausgebildet sind, dass auf den Seitenwänden verlaufende direkte Verbindungslinien zwischen dem Strahlungseingang und dem Strahlungsausgang im wesentlichen gerade verlaufen.

6. Beleuchtungseinrichtung nach einem der Ansprüche 1 bis 5, **dadurch gekennzeichnet, dass** das optische Element einen Strahlungsausgang mit einer linsenartig gewölbten Grenzfläche aufweist.

7. Beleuchtungseinrichtung nach einem der Ansprüche 1 bis 6, **dadurch gekennzeichnet, dass** eine Mehrzahl von Halbleiterchips enthalten ist und ein Teil benachbarter Halbleiterchips oder alle benachbarten Halbleiterchips zueinander einen Abstand von kleiner als oder gleich 300 µm und größer als oder gleich 0 µm aufweisen.

8. Beleuchtungseinrichtung nach Anspruch 7, **dadurch gekennzeichnet, dass** ein Teil benachbarter Halbleiterchips oder alle benachbarten Halbleiterchips einen Abstand von kleiner als oder gleich 100 µm und größer als oder gleich 0 µm aufweisen.

9. Beleuchtungseinrichtung nach einem der Ansprüche 1 bis 8, **dadurch gekennzeichnet, dass** ein Strahleneingang des optischen Elements zu den ihm zugeordneten Halbleiterchips einen Abstand von kleiner als oder gleich 300 µm, bevorzugt von kleiner als oder gleich 200 µm und größer als 0 µm aufweist.

10. Beleuchtungseinrichtung nach einem der Ansprüche 1 bis 9,
**dadurch gekennzeichnet, dass**
mehrere Halbleiterchips enthalten sind, denen das optische Element gemeinsam zugeordnet ist.

11. Beleuchtungseinrichtung nach einem der Ansprüche 1 bis 10, **dadurch gekennzeichnet, dass**
mehrere Halbleiterchips und mehrere optische Elemente enthalten sind, wobei zumindest einigen der Halbleiterchips jeweils ein eigenes optisches Element zugeordnet ist.

12. Beleuchtungseinrichtung nach einem der Ansprüche 1 bis 11,
**dadurch gekennzeichnet, dass**
die Verkapselungsschicht (3) ein Lumineszenz-Konversionsmaterial enthält.

13. Beleuchtungseinrichtung nach einem der Ansprüche 1 bis 12,
**dadurch gekennzeichnet, dass**
die Verkapselungsschicht (3) eine Kunststoffschicht ist.

14. Beleuchtungseinrichtung nach Anspruch 13,
**dadurch gekennzeichnet, dass**
die Verkapselungsschicht (3) Silikon enthält.

15. Beleuchtungseinrichtung nach einem der Ansprüche 1 bis 12,
**dadurch gekennzeichnet, dass**
die Verkapselungsschicht (3) eine Glasschicht ist.

16. Beleuchtungseinrichtung nach einem der vorhergehenden Ansprüche,
**dadurch gekennzeichnet, dass**
die erste Kontaktfläche (4) an der ersten Hauptfläche (2) des Halbleiterchips angeordnet ist, wobei der Halbleiterchip (1) mit der ersten Kontaktfläche (4) mittels einer elektrisch leitfähigen Verbindung auf dem ersten Anschlussbereich (7) montiert ist.

17. Beleuchtungseinrichtung nach einem der Ansprüche 1 bis 15,
**dadurch gekennzeichnet, dass**
die erste Kontaktfläche an der zweiten Hauptfläche (5) des Halbleiterchips (1) angeordnet ist, und eine weitere elektrisch leitfähige Schicht von der ersten Kontaktfläche über einen Teilbereich der Verkapselungsschicht (3) geführt ist, zum elektrisch leitfähigen Verbinden der ersten Kontaktfläche mit dem ersten Anschlussbereich (7).

18. Beleuchtungseinrichtung nach einem der vorhergehenden Ansprüche,
**dadurch gekennzeichnet, dass**
die elektrisch leitfähige Schicht (14) eine für die emittierte Strahlung transparente Schicht ist.

19. Beleuchtungseinrichtung nach Anspruch 18,
**dadurch gekennzeichnet, dass**
die elektrisch leitfähige Schicht (14) ein transparentes leitfähiges Oxid, vorzugsweise Indium-Zinn-Oxid, enthält.

20. Beleuchtungseinrichtung nach einem der Ansprüche 1 bis 17,
**dadurch gekennzeichnet, dass**
die elektrisch leitfähige Schicht (14) eine strukturierte Metallschicht ist.

21. Beleuchtungseinrichtung nach einem der vorhergehenden Ansprüche,
**dadurch gekennzeichnet, dass**
eine isolierende Deckschicht (15) auf die elektrisch leitfähige Schicht (14) aufgebracht ist.

22. Beleuchtungseinrichtung nach Anspruch 21,
**dadurch gekennzeichnet, dass**
die Deckschicht (15) eine Glasschicht ist.

23. Verfahren zur Herstellung einer Beleuchtungseinrichtung mit einem Halbleiterchip (1), der eine erste Hauptfläche (2), eine erste Kontaktfläche (4) und eine der ersten Hauptfläche (2) gegenüberliegende zweite Hauptfläche (5) mit einer zweiten Kontaktfläche (6) aufweist, sowie mit einem Trägerkörper (10), wobei bei dem Verfahren ein elektrisch leitendes Verbinden der ersten Kontaktfläche mit einem ersten Anschlussbereich auf dem Trägerkörper erfolgt, **gekennzeichnet durch** die weiteren Verfahrensschritte:
- Montage des Halbleiterchips (1) mit der ersten Hauptfläche (2) auf den Trägerkörper (10),
- Aufbringen einer transparenten elektrisch isolierenden Verkapselungsschicht (3) auf den Halbleiterchip (1) und den Trägerkörper (10),
- Erzeugung einer ersten Ausnehmung (11) in der Verkapselungsschicht (3) zur zumindest teilweisen Freilegung der zweiten Kontaktfläche (6) des Halbleiterchips (1) und einer zweiten Ausnehmung (12) in der Verkapselungsschicht (3) zur zumindest teilweisen Freilegung eines zweiten Anschlussbereichs (8) auf dem Trägerkörper, wobei dern von zweite Auschlußbereich dem ersten Anschlussbereich isoliert ist,
- Aufbringen einer elektrisch leitfähigen Schicht (14) auf die zweite Kontaktfläche (6) und die Verkapselungsschicht (3), zum elektrisch leitenden Verbinden der zweiten Kontaktfläche (6) des Halbleiterchips mit dem zweiten Anschlussbereich (8),
- Anordnen eines optischen Elements derart, dass es dem Halbleiterchip zugeordnet ist und dass ein Teil der elektrisch leitfähigen Schicht zwischen dem optischen Element und der zweiten Hauptfläche angeordnet ist.

24. Verfahren nach Anspruch 23,
**dadurch gekennzeichnet, dass**
die Verkapselungsschicht (3) eine Kunststoffschicht ist.

25. Verfahren nach Anspruch 23 oder 24,
**dadurch gekennzeichnet, dass**
die Verkapselungsschicht (3) durch Auflaminieren einer Folie, Aufdrucken, Aufsprühen oder Aufschleudern aufgebracht wird.

26. Verfahren nach Anspruch 23,
**dadurch gekennzeichnet, dass**
die Verkapselungsschicht (3) eine Glasschicht ist.

27. Verfahren nach Anspruch 26,
**dadurch gekennzeichnet, dass**
das Aufbringen der Verkapselungsschicht (3) die Verfahrenschritte umfasst:
- Aufbringen einer Precursorschicht (9), die anorgansiche und organische Bestandteile enthält,
- eine erste Temperaturbehandlung zur Entfernung der organischen Bestandteile aus der Precursorschicht (9),
- eine zweite Temperaturbehandlung, um die Precursorschicht (9) in eine Glasschicht (3) zu verdichten.

28. Verfahren nach einem der Ansprüche 23 bis 27,
**dadurch gekennzeichnet, dass**
die erste Ausnehmung (11) und die zweite Ausnehmung (12) in der Verkapselungsschicht (3) durch eine Laserbearbeitung erzeugt werden.

29. Verfahren nach einem der Ansprüche 23 bis 28,
**dadurch gekennzeichnet, dass**
zur Herstellung der elektrisch leitfähigen Schicht (14) eine Metallschicht mit einem PVD-Verfahren aufgebracht und nachfolgend mittels galvanischer Abscheidung verstärkt wird.

30. Verfahren nach einem der Ansprüche 23 bis 28,
**dadurch gekennzeichnet, dass**
die elektrisch leitfähige Schicht (14) mit einem Druckverfahren aufgebracht wird.

31. Verfahren nach einem der Ansprüche 23 bis 28,
**dadurch gekennzeichnet, dass**
die elektrisch leitfähige Schicht (14) durch Aufsprühen oder Aufschleudern aufgebracht wird.

32. Verfahren nach einem der Ansprüche 23 bis 31,
**dadurch gekennzeichnet, dass**
eine elektrisch isolierende Deckschicht (15) auf die elektrisch leitfähige Schicht (14) aufgebracht wird.

33. Verfahren nach Anspruch 32,
**dadurch gekennzeichnet, dass**
die Deckschicht (15) eine Glasschicht ist.

34. Verfahren nach Anspruch 33,
**dadurch gekennzeichnet, dass**
das Aufbringen der Deckschicht (15) die Verfahrenschritte umfasst:
- Aufbringen einer Precursorschicht (9), die anorganische und organische Bestandteile enthält,
- eine erste Temperaturbehandlung zur Entfernung der organischen Bestandteile aus der Precursorschicht (9),
- eine zweite Temperaturbehandlung, um die Precursorschicht (15) in eine Glasschicht zu verdichten.

## Claims

1. A lighting device with a semiconductor chip (1), which has a first main surface (2), a first contact area (4), and a second main surface (5) lying opposite the first main surface (2) with a second contact area (6), and with a support body (10) on which the semiconductor chip (1) is affixed with the first main surface (2),
wherein the first contact area is electrically connected to a first terminal region on the support body, **characterized in that**
- the semiconductor chip (1) and the support body (10) are provided with a transparent, electrically isolating encapsulation layer (3),
- an optical element is assigned to the semiconductor chip,
- radiation of the semiconductor chip emitted in a main direction of radiation (13) is transmitted through the encapsulation layer (3) and is coupled into the optical element, and
- between the optical element and the second main surface there is arranged a part of an electrically conductive layer (14) that is brought from the second contact area (6) over a partial region of the encapsulation layer (3) for electrically conductively connecting the second contact area with a second terminal region (8) on the support body, wherein the second terminal region is isolated from the first terminal region.

2. A lighting device as in Claim 1, **characterized in that** the lighting device is a head lamp or a projection application.

3. A lighting device as in one of Claims 1 and 2, **characterized in that** the optical element is designed in the manner of a nonimaging optical concentrator which, compared to the usual use of a concentrator, is intended for transmitting radiation in the reverse direction.

4. A lighting device as in Claim 3, **characterized in that** the optical element is an optical concentrator in the manner of a compound parabolic concentrator, a compound elliptical concentrator or a compound hyperbolic concentrator.

5. A lighting device as in Claim 3, **characterized in that** the concentrator has side walls that connect a radiation entrance to a radiation exit of the concentrator and that are designed so that direct connecting lines running on the side walls between the radiation entrance and the radiation exit are essentially straight.

6. A lighting device as in one of Claims 1-5, **characterized in that** the optical element has a radiation exit with a boundary surface that is curved in lens fashion.

7. A lighting device as in one of Claims 1-6, **characterized in that** a plurality of semiconductor chips is contained in it and a part of adjacent semiconductor chips or all adjacent semiconductor chips have a spacing from each other that is less than or equal to 300 µm and greater than or equal to 0 µm.

8. A lighting device as in Claim 7, **characterized in that** a part of adjacent semiconductor chips or all adjacent semiconductor chips have a spacing of less than or equal to 100 µm and greater than or equal to 0 µm.

9. A lighting device as in one of Claims 1-8, **characterized in that** a radiation entrance of the optical element has a spacing to its associated semiconductor chips of less than or equal to 300 µm, preferably less than or equal to 200 µm and greater than 0 µm.

10. A lighting device as in one of Claims 1-9, **characterized in that** it contains a plurality of semiconductor chips, to which the optical element is jointly assigned.

11. A lighting device as in one of Claims 1-10, **characterized in that** it contains a plurality of semiconductor chips and a plurality of optical elements, wherein at least some of the semiconductor chips are in each case assigned to a separate optical element.

12. A lighting device as in one of Claims 1-11, **characterized in that** the encapsulation layer (3) contains a luminescence conversion material.

13. A lighting device as in one of Claims 1-12, **characterized in that** the encapsulation layer (3) is a plastic layer.

14. A lighting device as in Claim 13, **characterized in that** the encapsulation layer (3) contains silicone.

15. A lighting device as in one of Claims 1-12, **characterized in that** the encapsulation layer (3) is a glass layer.

16. A lighting device as in one of the preceding claims, **characterized in that** the first contact area (4) is arranged on the first main surface (2) of the semiconductor chip, wherein the semiconductor chip (1) is mounted with the first contact area (4) by means of an electrically conductive connection to the first terminal region (7).

17. A lighting device as in one of Claims 1-15, **characterized in that** the first contact area is arranged on the second main surface (5) of the semiconductor chip (1), and an additional electrically conductive layer is brought from the first contact area over a partial region of the encapsulation layer (3) for electrically conductively connecting the first contact area with the first terminal region (7).

18. A lighting device as in one of the preceding claims, **characterized in that** the electrically conductive layer (14) is a layer that is transparent for the emitted radiation.

19. A lighting device as in Claim 18, **characterized in that** the electrically conductive layer (14) comprises a transparent conductive oxide, preferably indium-tin oxide.

20. A lighting device as in one of Claims 1-17, **characterized in that** the electrically conductive layer (14) is a structured metal layer.

21. A lighting device as in one of the preceding claims, **characterized in that** an isolating cover layer (15) is applied to the electrically conductive layer (14).

22. A lighting device as in Claim 21, **characterized in that** the cover layer (15) is a glass layer.

23. A process for producing a lighting device with a semiconductor chip (1), which has a first main surface (2), a first contact area (4) and a second main surface (5) with a second contact area (6) lying opposite the first main surface (2), and with a support body (10), where in the process an electrically conductive connection is made between the first contact area and a first terminal region on the support body, **characterized by** the additional process steps:
- mounting of the semiconductor chip (1) with the first main surface (2) on the support body (10),
- application of a transparent electrically isolating encapsulation layer (3) on the semiconductor chip (1) and the support body (10),
- creation of a first recess (11) in the encapsulation layer (3) for at least partial exposure of the second contact area (6) of the semiconductor chip (1) and a second recess (12) in the encapsulation layer (3) for at least partial exposure of a second terminal region (8), on the support body, where the second terminal region is isolated from the first terminal region,
- application of an electrically conductive layer (14) on the second contact area (6) and the encapsulation layer (3) for electrically conductive connection of the second contact area (6) of the semiconductor chip to the second terminal region (8),
- arrangement of an optical element so that it is assigned to the semiconductor chip and that a part of the electrically conductive layer is arranged between the optical element and the second main surface.

24. A process as in Claim 23, **characterized in that** the encapsulation layer (3) is a plastic layer.

25. A process as in Claim 23 or 24, **characterized in that** the encapsulation layer (3) is applied by lamination of a film, printing, spraying or spin coating.

26. A process as in Claim 23, **characterized in that** the encapsulation layer (3) is a glass layer.

27. A process as in Claim 26, **characterized in that** the application of the encapsulation layer (3) comprises the process steps:
- application of a precursor layer (9), which contains inorganic and organic components,
- a first heat treatment to remove the organic components from the precursor layer (9),
- a second heat treatment to consolidate the precursor layer (9) into a glass layer (3).

28. A process as in one of Claims 23-27, **characterized in that** the first recess (11) and the second recess (12) in the encapsulation layer (3) are created by laser machining.

29. A process as in one of Claims 23-28, **characterized in that** to produce the electrically conductive layer (14) a metal layer is applied with a PVD process and then made thicker by electrolytic deposition.

30. A process as in one of Claims 23-28, **characterized in that** the electrically conductive layer (14) is applied with a printing process.

31. A process as in one of Claims 23-28, **characterized in that** the electrically conductive layer (14) is applied by spraying or spin coating.

32. A process as in one of Claims 23-31, **characterized in that** an electrically isolating cover layer (15) is applied to the electrically conductive layer (14).

33. A process as in Claim 32, **characterized in that** the cover layer (15) is a glass layer.

34. A process as in Claim 33, **characterized in that** the application of the cover layer (15) comprises the process steps:
- application of a precursor layer (9), which contains inorganic and organic components,
- a first heat treatment to remove the organic components from the precursor layer (9),
- a second heat treatment to consolidate the precursor layer (15) into a glass layer.

## Revendications

1. Un dispositif d'éclairage avec une puce semi-conductrice (1), muni d'une première surface principale (2), d'une première surface de contact (4) et d'une deuxième surface principale (5) située à l'opposé de la première surface principale (2) avec une deuxième surface de contact (6) et disposant d'un cadre du support (10) sur lequel la puce semi-conductrice (1) est fixée à la première surface principale (2),
où la première surface de contact est électriquement reliée à une première zone de borne de raccordement qui se trouve sur le cadre du support se caractéris par le fait que :
- la puce semi-conductrice (1) et le cadre du support (10) sont fournis avec une couche transparente d'encapsulation d'isolation électrique (3),
- un élément optique est attribué à la puce semi-conductrice,
- le rayonnement de la puce semi-conductrice émis dans une direction principale de rayonnement (13) est transmis à travers la couche d'encapsulation (3) et est associé à l'élément optique et
- qu'entre l'élément optique et la deuxième surface principale est disposée une partie d'une couche électriquement conductrice (14) qui est amenée de la deuxième surface de contact (6) par-dessus une région de la couche d'encapsulation (3) vers une connexion électriquement conductrice de la deuxième surface de contact avec une deuxième zone de raccordement (8) sur le cadre du support, tandis que la deuxième zone de raccordement est isolée de la première zone de raccordement.

2. Un dispositif d'éclairage conforme à celui de la revendication 1 qui se **caractérise par le fait que** le dispositif d'éclairage est un phare ou une application de projection.

3. Un dispositif d'éclairage conforme à celui des revendications 1 et 2 qui se **caractérise par le fait que** l'élément optique est conçu de la manière d'un concentrateur optique sans formation d'image qui, comparé à l'utilisation normale d'un concentrateur, sert à un rayonnement dans le sens opposé.

4. Un dispositif d'éclairage conforme à celui de la revendication 3 qui se **caractérise par le fait que** l'élément optique est un concentrateur optique qui ressemble à un concentrateur parabolique composite, un concentrateur elliptique composite ou un concentrateur hyperbolique composite.

5. Un dispositif d'éclairage conforme à celui de la revendication 3 qui se **caractérise par le fait que** le concentrateur dispose de parois latérales qui relient une entrée de rayonnement à une sortie de rayonnement du concentrateur et qui sont conçues de telle manière que les lignes de raccordement directes installées sur les parois latérales entre l'entrée de rayonnement et la sortie de rayonnement sont essentiellement droites.

6. Un dispositif d'éclairage conforme à celui des revendications 1 à 5 qui se **caractérise par le fait que** l'élément optique dispose d'une sortie de rayonnement qui a une surface frontière en forme d'arc comme une lentille.

7. Un dispositif d'éclairage conforme à celui des revendications 1 à 6 qui se **caractérise par le fait qu'**il comporte une variété de puces semi-conductrices et qu'une partie des puces semi-conductrices adjacentes ou l'ensemble des puces semi-conductrices adjacentes a un espacement entre elles qui est inférieur ou égal à 300 µm et supérieur ou égal à 0 µm.

8. Un dispositif d'éclairage conforme à celui de la revendication 7 qui se **caractérise par le fait qu'**une partie des puces semi-conductrices adjacentes ou l'ensemble des puces semi-conductrices adjacentes a un espacement inférieur ou égal à 100 µm et supérieur ou égal à 0 µm.

9. Un dispositif d'éclairage conforme à celui des revendications 1 à 8 qui se **caractérise par le fait qu'**une entrée de rayonnement de l'élément optique a un espacement avec sa puce semi-conductrice associée, inférieur ou égal à 300 µm, préférablement inférieur ou égal à 200 µm et supérieur à 0 µm.

10. Un dispositif d'éclairage conforme à celui des revendications 1 à 9 qui se **caractérise par le fait qu'**il contient plusieurs puces semi-conductrices auxquelles l'élément optique est conjointement attribué.

11. Un dispositif d'éclairage conforme à celui des revendications 1 à 10 qui se **caractérise par le fait qu'**il contient une variété de puces semi-conductrices et une variété d'éléments optiques où au moins un élément optique est attribué à certaines des puces semi-conductrices.

12. Un dispositif d'éclairage conforme à celui des revendications 1 à 11 qui se **caractérise par le fait que** la couche d'encapsulation (3) contient un matériau de conversion de luminescence.

13. Un dispositif d'éclairage conforme à celui des revendications 1 à 12 qui se **caractérise par le fait que** la couche d'encapsulation (3) est une couche en plastique.

14. Un dispositif d'éclairage conforme à celui de la revendication 13 qui se **caractérise par le fait que** la couche d'encapsulation (3) contient de la silicone.

15. Un dispositif d'éclairage conforme à celui des revendications 1 à 12 qui se **caractérise par le fait que** la couche d'encapsulation (3) est une couche en verre.

16. Un dispositif d'éclairage conforme à celui des revendications précédentes qui se **caractérise par le fait que** la première surface de contact (4) est disposée sur la première surface principale (2) de la puce semi-conductrice, laquelle puce semi-conductrice (1) est montée à la première zone de contact (4) au moyen d'un raccordement électriquement conducteur vers la première zone de raccordement (7).

17. Un dispositif d'éclairage conforme à celui des revendications 1 à 15 qui se **caractérise par le fait que** la première surface de contact est disposée sur la deuxième surface principale (5) de la puce semi-conductrice (1) et qu'une couche électriquement conductrice supplémentaire est amenée de la première surface de contact par-dessus une zone partielle de la couche d'encapsulation (3) vers un raccordement électriquement conducteur de la première surface de contact avec la première zone de raccordement (7).

18. Un dispositif d'éclairage conforme à celui des revendications précédentes qui se **caractérise par le fait que** la couche électriquement conductrice (14) est une couche qui est transparente pour le rayonnement émis.

19. Un dispositif d'éclairage conforme à la revendication 18 qui se **caractérise par le fait que** la couche électriquement conductrice (14) contient un transparente oxyde conducteur, l'oxyde d'étain et d'indium de préférence.

20. Un dispositif d'éclairage conforme à celui des revendications 1 à 17 qui se **caractérise par le fait que** la couche électriquement conductrice (14) est une couche de métal structurée.

21. Un dispositif d'éclairage conforme à celui des revendications précédentes qui se **caractérise par le fait qu'**une couche de revêtement d'isolation (15) est appliquée à la couche électriquement conductrice (14).

22. Un dispositif d'éclairage conforme à la revendication 21 qui se **caractérise par le fait que** la couche de revêtement (15) est une couche en verre.

23. Un procédé servant à produire un dispositif d'éclairage muni d'une puce semi-conductrice (1) disposant d'une première surface principale (2), d'une première surface de contact (4) et d'une deuxième surface principale (5) avec une deuxième surface de contact (6) située à l'opposé de la première surface principale (2) et avec un cadre du support (10) où dans le procédé un raccordement électriquement conducteur est effectué entre la première surface de contact et une première zone de raccordement se trouvant sur le cadre du support, qui se **caractérise par** les étapes de procédé supplémentaires suivantes :
- montage de la puce semi-conductrice (1) avec la première surface principale (2) sur le cadre du support (10),
- application d'une couche transparente d'encapsulation d'isolation électrique (3) sur la puce semi-conductrice (1) et le cadre du support (10),
- création d'un premier renfoncement (11) dans la couche d'encapsulation (3) pour au moins une exposition partielle de la deuxième surface de contact (6) de la puce semi-conductrice (1) et d'un deuxième renfoncement (12) dans la couche d'encapsulation (3) pour au moins une exposition partielle de la deuxième zone de raccordement (8) sur le cadre du support, laquelle deuxième zone de raccordement est isolée de la première zone de raccordement,
- application d'une couche électriquement conductrice (14) sur la deuxième surface de contact (6) et sur la couche d'encapsulation (3) afin de permettre un raccordement électriquement conducteur entre la deuxième surface de contact (6) de la puce semi-conductrice et la deuxième zone de raccordement (8),
- disposition d'un élément optique de sorte qu'il soit attribué à une puce semi-conductrice et qu'une partie de la couche électriquement conductrice soit disposée entre l'élément optique et la deuxième surface principale.

24. Un procédé conforme à celui de la revendication 23 qui se **caractérise par le fait que** la couche d'encapsulation (3) est une couche en plastique.

25. Un procédé conforme à celui de la revendication 23 ou la revendication 24 qui se **caractérise par le fait que** la couche d'encapsulation (3) est appliquée par laminage d'un film, impression, pulvérisation ou application par centrifugation.

26. Un procédé conforme à celui de la revendication 23 qui se **caractérise par le fait que** la couche d'encapsulation (3) est une couche en verre.

27. Un procédé conforme à celui de la revendication 26 qui se **caractérise par le fait que** l'application de la couche d'encapsulation (3) comporte les étapes de procédé suivantes :
- application d'une couche de matériau précurseur (9) qui contient des composants organiques et inorganiques,
- un premier traitement thermique destiné à éliminer les composants organiques de la couche du matériau précurseur (9),
- un deuxième traitement thermique destiné à compresser la couche du matériau précurseur (9) en une couche de verre (3).

28. Un procédé conforme à celui des revendications 23 à 27 qui se **caractérise par le fait que** le premier renfoncement (11) et le deuxième renfoncement (12) dans la couche d'encapsulation (3) sont créés par un usinage au laser.

29. Un procédé conforme à celui des revendications 23 à 28 qui se **caractérise par le fait que** pour produire une couche électriquement conductrice (14) une couche de métal est appliquée à l'aide d'un procédé PVD (procédé de dépôt en phase vapeur) puis est ensuite renforcée grâce à un dépôt électrolytique.

30. Un procédé conforme à celui des revendications 23 à 28 qui se **caractérise par le fait que** la couche électriquement conductrice (14) est appliquée à l'aide d'un procédé d'impression.

31. Un procédé conforme à celui des revendications 23 à 28 qui se **caractérise par le fait que** la couche électriquement conductrice (14) est appliquée via un procédé de pulvérisation ou de centrifugation.

32. Un procédé conforme à celui des revendications 23 à 31 qui se **caractérise par le fait que** la couche de revêtement d'isolation électrique (15) est appliquée à la couche électriquement conductrice (14).

33. Un procédé conforme à celui de la revendication 32 qui se **caractérise par le fait que** la couche de revêtement (15) est une couche en verre.

34. Un procédé conforme à celui de la revendication 33 qui se **caractérise par le fait que** l'application de la couche de revêtement (15) comprend les étapes de procédé suivantes :
- application d'une couche de matériau précurseur (9) qui contient des composants organiques et inorganiques,
- un premier traitement thermique destiné à éliminer les composants organiques de la couche du matériau précurseur (9),
- un deuxième traitement thermique destiné à compresser la couche du matériau précurseur (15) en une couche en verre.
